# DEMANDE DE BREVET EUROPEEN

(11) **EP 1 791 039 A1**
(43) Date de publication de la demande: **30.05.2007**
(21) Numéro de dépôt: 05025724.5
(22) Date de dépôt: 25.11.2005
(51) Int. Cl.: G04B 17/22, G04B 17/06, G04D 3/00, F16F 1/10, C03C 23/00

(54) **Spiral en verre athermique pour mouvement d'horlogerie et son procédé de fabrication**

(71) Demandeur: The Swatch Group Research and Development Ltd., 2074 Marin (CH)
(72) Inventeur: Hessler, Thierry, 1020 Renens (CH); Grupp, Joachim, 2073 Enges (CH)
(74) Mandataire: Thérond, Gérard Raymond

(57) **Abrégé**

Le spiral est réalisé à partir d'une plaque de verre photostructurable par irradiation UV, traitement thermique et attaque chimique, ledit verre ayant un coefficient thermique du module de Young CTE₀. Par irradiation UV à travers un ou plusieurs masques, éventuellement complétée par un traitement thermique, des zones choisies du spiral ont la valeur CTE₀ modifiée en une valeur CTEᵢ.

## Description

### Domaine technique

La présente invention concerne un spiral pour mouvement d'horlogerie réalisé en un verre spécial et par un procédé permettant de rendre ses propriétés mécaniques, et notamment son coefficient thermique du module de Young (CTE) à peu près totalement indépendant de la température, tout en bénéficiant de ses propriétés amagnétiques.

### Arrière plan technologique

On a depuis longtemps essayé de minimiser l'influence des variations de conditions extérieures, en particulier température et champ magnétique, sur l'isochronisme d'un système réglant balancier-spiral en agissant sur la construction et sur le choix des matériaux.

En ce qui concerne le spiral, depuis la découverte de l'invar, qui est un alliage Fe-Ni, au début du XXe siècle, on n'a cessé de proposer des compositions d'alliage de plus en plus complexes pour tendre vers la qualité optimum. Le brevet EP 0 886 195 décrit par exemple des compositions d'alliage au Niobium et au Zirconium contenant en outre un agent dopant interstitiel formé au moins en partie d'oxygène et permettant de contrôler la valeur du CTE. Compte-tenu de la complexité des compositions et de l'utilisation de métaux rares, le produit final a un coût élevé. De plus la fabrication d'un spiral métallique fait appel à des procédés métallurgiques complexes (tréfilage, écrouissage, recuit, etc...) ne permettant pas de garantir une parfaite reproductibilité des propriétés élastiques souhaitées, de sorte qu'il est encore nécessaire de procéder à l'appairage du balancier et du spiral lors du montage.

On a également essayé depuis longtemps de remplacer un alliage par un autre matériau n'ayant pas les inconvénients du métal. Le brevet CH 307 683 publié en 1955 propose de fabriquer un spiral en verre ayant une teneur en silice telle que son coefficient de dilatation ait une valeur pratiquement nulle sans qu'il soit nécessaire d'ajouter un quelconque métal rare. Ce document ne décrit pas comment est façonné un tel spiral, ni quelle est l'influence sur le CTE.

Un document plus récent, EP 1519250 décrit un résonateur balancier-spiral thermocompensé grâce à la découpe et la structuration selon des orientations déterminées par rapport aux axes cristallographiques d'un cristal de quartz. Un tel procédé de fabrication ne peut être mis en oeuvre que par des personnes qualifiées. On observera d'autre part que la nature cristalline du quartz rend le spiral cassant sous le choc en provoquant des fissures qui se propagent le long des plans cristallins.

### Résumé de l'invention

La présente invention vise donc à palier les inconvénients de l'art antérieur précité en procurant un spiral en verre fabriqué selon un procédé permettant à la fois de contrôler localement les propriétés mécaniques, notamment le coefficient thermique du module de Young (CTE) dudit spiral ainsi que son coefficient d'élasticité et de pouvoir effectuer une fabrication en lot à moindre coût.

A cet effet le matériau choisi pour fabriquer un spiral en verre composé de spires de hauteur uniforme h et localement de largeur l est un verre photostructurable ayant initialement un coefficient thermique du module de Young (CTEₒ) de préférence voisin de zéro. Un tel verre permet de modifier localement le coefficient thermique du module de Young (CTEᵢ) par irradiation, ladite irradiation étant éventuellement complétée par un traitement thermique à haute température.

Cette modification peut être effectuée pour une ou plusieurs spires ou zones de spires en ayant des CTEᵢ différents le long du spiral. La modification du CTEᵢ peut également être effectuée sur une partie de la largeur des spires, sur tout ou partie de leur longueur, voire sur seulement une partie de la hauteur des spires.

Un tel spiral peut être fabriqué en lot à partir d'une plaque de verre photostructurable ayant pour coefficient du module de Young CTE₀, selon deux procédés reposant sur les mêmes principes.

Selon un premier procédé, on effectue à travers un premier masque une illumination UV sur des zones du verre correspondant aux espaces devant être ultérieurement libérés entre les spires. Dans l'étape suivante on effectue un traitement thermique à haute température qui permet de fragiliser les zones ayant été illuminées, sans pour autant avoir un effet destructif. Dans l'étape suivante on effectue une nouvelle illumination UV à travers un deuxième masque dont les fenêtres sont disposées au dessus de spires, zones de spires, sur tout ou partie de leur largeur pour modifier le CTE₀ initial à une valeur CTEᵢ. L'étape précédente peut être renouvelée avec un troisième masque, et avec des caractéristiques d'illumination UV permettant de modifier le CTE₀ initial à une valeur CTE₂ sur seulement une partie de la hauteur du spiral, de préférence en effectuant cette étape à la fois sur les surfaces supérieure et inférieure dudit spiral.

Il est bien évident que les deuxième et troisième masques peuvent avoir des zones de fenêtre communes, faisant que le CTE₀ initial est modifié à une valeur CTE₃ pouvant être différente des précédentes.

Dans une dernière étape on élimine par attaque chimique les zones entre les spires qui ont été fragilisées par traitement UV et thermique.

Selon un deuxième procédé on assujettit une plaque de verre à un substrat insensible aux attaques acides et on effectue d'abord la conformation du spiral au moyen d'un premier masque par illumination UV, et traitement thermique puis attaque acide. A l'issue de cette étape les spires sont séparées mais restent liées au substrat. Dans au moins une étape suivante on effectue une illumination UV à travers un masque dont les fenêtres correspondent à des zones de spires dont on veut modifier le CTEᵢ. Dans une dernière étape on libère le spiral du substrat et on effectue éventuellement un traitement thermique additionnel pour obtenir un ajustement supplémentaire du CTE.

Si cela est nécessaire, il est possible d'effectuer un traitement thermique additionnel pour obtenir un ajustement supplémentaire du CTE, après chaque illumination UV visant à modifier CTE₀, que ce soit dans le premier ou le deuxième procédé.

Selon un autre aspect de l'invention, le masque utilisé pour définir le contour du spiral peut également permettre de faire varier le pas et/ou la largeur des spires le long dudit spiral ou sur des zones déterminées de spire.

Selon encore un autre aspect de l'invention, par le choix d'une source de radiation appropriée, il est possible de modifier localement le CTE₀ dans toute la hauteur de la spire, ou seulement sur une partie de sa hauteur.

### Brève description des dessins

D'autres caractéristiques et avantages de la présente invention apparaîtront dans la description suivante de divers modes de réalisation donnés à titre illustratif et non limitatif, en référence aux dessins annexés dans lesquels :
- la figure 1 représente un spiral en verre;
- les figures 2 à 6 représentent en vue de dessus différentes façons de modifier une zone choisie du spiral;
- les figures 7 à 9 représentent les étapes d'un premier procédé permettant de modifier une zone choisie du spiral;
- les figures 10A, 10B et 10C représentent les sections de trois spires différentes modifiées par le premier procédé;
- les figures 11 à 13 représentent un deuxième procédé permettant de modifier une zone choisie du spiral, et
- les figures 14A, 14B et 14C représentent les sections droites de trois spires différentes, modifiées par le deuxième procédé.

### Description détaillée de l'invention

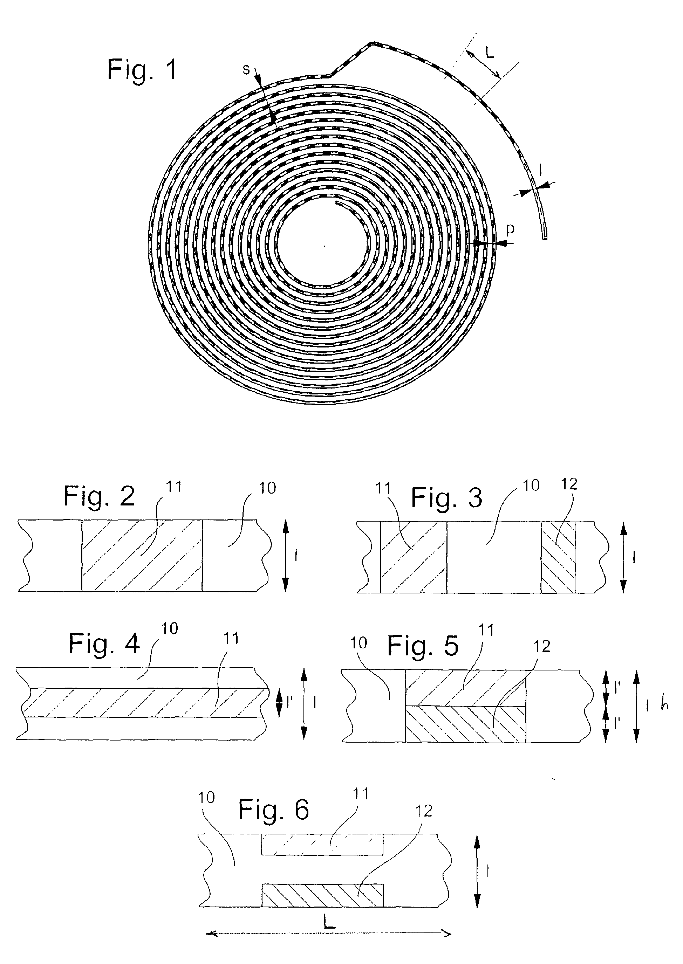

A la figure 1 on a représenté en vue de dessus un spiral réalisé à partir d'un verre photostructurable ayant un faible coefficient thermique du module de Young CTE₀. On connaît un très grand nombre de verres, dont les compositions à base de silicates incorporent certains dopants et/ou adjuvants, tels que des oxydes de cérium, d'argent, d'étain, ou d'antimoine qui vont rendre des parties de ce verre, soumises à irradiation ultraviolette et traitement thermique, chimiquement facilement attaquables de façon anisotropique, par exemple par une solution d'acide fluorhydrique. Cette propriété est bien connue et déjà utilisée pour fabriquer par exemples des dispositifs microfluidiques. De tels verres sont par exemples disponibles chez Schott AG en Allemagne sous la marque Foturan ^{®}ou chez Hoya Corp au Japon, sous la référence PEG 3. De tels verres photostructurables ne sont actuellement utilisés que pour leurs propriétés permettant d'obtenir des MEMS par des techniques d'usinage non conventionnelles.

Les figures 2 à 6 représentent en vue de dessus des exemples de modification du CTE d'une zone L de spire d'un spiral ayant initialement un coefficient thermique du module de Young de CTE₀.

La figure 2 montre que, pour une zone 11, sur toute la largeur I, le CTE₀ initial a été modifié en CTE₁. Il est bien évident que cette modification peut s'étendre sur plusieurs spires, voire permettre d'alterner des zones de spire ayant des coefficients thermiques du module de Young CTE₀ et CTE₁.

Comme représenté à la figure 3, il est également possible de modifier plusieurs fois le coefficient thermique du module de Young initial CTE₀ pour avoir une valeur CTE₁ dans une zone 11 et CTE₂ dans une zone 12, ces zones étant séparées par une zone 10 à CTE₀. Les zones 11 et 12 pourraient également être jointives.

Selon un autre mode de réalisation représenté à la figure 4, il est possible de modifier le coefficient thermique initial du module de Young CTE₀ seulement sur une zone 11 du spiral ayant une largeur l'inférieure à I. Dans l'exemple représenté, la zone 11 est située sensiblement au centre, mais il est bien évident qu'elle pourrait être prévue dans l'épaisseur de la surface extérieure ou de surface intérieure, soit encore dans les deux en même temps.

La figure 5 illustre une autre variante dans laquelle le coefficient thermique du module de Young est modifié de la valeur CTE₀ à une valeur CTE₁ dans une zone 11 extérieure de largeur l' et à une valeur CTE₂ dans une zone 12 intérieure de largeur I", ces deux zones étant jointives.

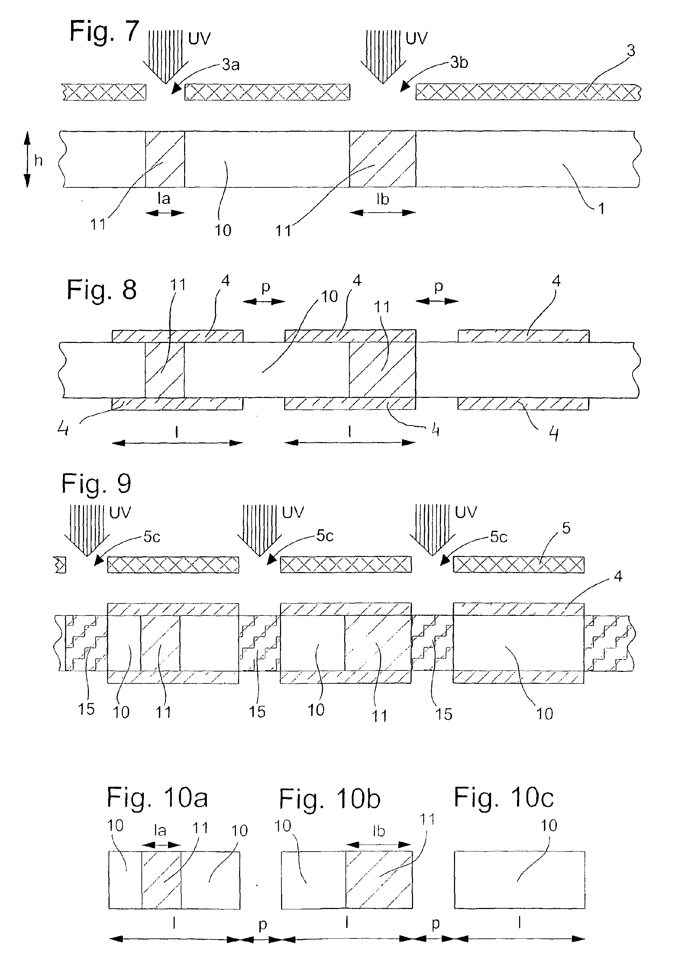

La figure 6 illustre la possibilité d'avoir dans une zone donnée du spiral selon la section droite, une valeur CTE₁ dans une zone 11, une valeur CTE₂ dans une zone 12 et une valeur CTE₀ dans une zone située entre les zones 11 et 12. D'autres possibilités seront illustrées dans la suite de la description.

En ayant cette liberté de modifier le CTE₀ initial du verre photostructurable utilisé, on crée en quelque sorte un CTE "apparent" optimisé pour obtenir une fréquence du système balancier-spiral pratiquement indépendante des variations de température même si le CTE₀ initial est un peu éloigné de la valeur optimale zéro.

Il est également à noter que le procédé, en même temps que la modification du CTE, peuvent avoir une influence favorable sur le coefficient de dilatation αₛ, qui intervient dans la détermination de la fréquence, même si son influence est nettement moins importante.

On se réfère maintenant aux figures 7 à 10c pour décrire un premier mode de réalisation d'un spiral en verre selon l'invention.

Les figures 7 à 10c représentent en coupe, selon la flèche S, trois spires jointives de hauteur h, étant fait observer que le rapport hauteur/largeur de spire n'est pas respecté pour une meilleure compréhension des dessins.

Partant d'une plaque de verre 1, ayant pour coefficient thermique du module de Young initial CTE₀ et une épaisseur h éventuellement obtenue par usinage et polissage, on effectue comme représenté à la figure 7 une illumination UV à travers un masque 3. Le masque 3 comporte une fenêtre 3a dont l'ouverture est située au dessus de zones 15 devant ultérieurement être éliminées pour obtenir l'espace qu'on souhaite avoir entre les spires, c'est à dire un pas p, qui dans cet exemple reste constant en tout point, les spires ayant une largeur uniforme I. La source de radiation UV utilisée dépend de la bande d'absorption du verre utilisé. Il s'agit par exemple d'une lampe UV dont le pic de distribution spectral est situé entre 200 et 400 nm. Il est également possible d'utiliser une autre source de radiation tel qu'un laser Eximer XeCl₂ dont le pic d'émission est situé 308 nm, ou KrF₂ ayant un pic d'émission à 248 nm.

Dans l'étape suivante, non représentée, la plaque de verre photostructurable 1 est soumise à un traitement thermique à haute température, de l'ordre de 600°C selon la composition du verre. Ce traitement thermique permet de rendre les zones 15 ayant eues une illumination UV plus facilement et sélectivement éliminables par une attaque chimique ultérieure.

Dans l'étape représentée à la figure 8, un deuxième masque 5 comporte des fenêtres 5a, 5b etc....disposées au dessus des spires ou de zones de spires 11 dont on veut modifier le CTE₀ initial à une valeur CTE₁ déterminée, par irradiation UV à travers lesdites fenêtres. On observera que ces fenêtres peuvent être prévues sur seulement une partie de la largeur d'une spire. A titre d'exemple la fenêtre 5b a une largeur I_{b} située sensiblement dans la partie médiane de la spire, et la fenêtre 5c a une largeur l_{c} située sur un bord de la spire.

A ce stade du procédé il est possible d'effectuer l'attaque chimique qui va permettre d'éliminer sélectivement les zones 15 et de libérer les spires. Cette attaque chimique est effectuée de façon classique, par exemple dans un bain d'acide fluorhydrique à environ 10%, à température ambiante et sous ultrasons.

Il est également possible d'effectuer un traitement thermique additionnel pour obtenir un ajustement supplémentaire des CTE modifiés.

Les figures 10a et 10b représentent à titre d'exemple les configurations possibles. La figure 10a montre une zone 11 de largeur I_{b} dont le CTE a été modifié en CTE₁, de part et d'autre de deux zones 10 dont le CTE₀ initial n'a pas été modifié. A la figure 10b la modification du CTE₀ à une valeur CTE₁ est effectuée sur une largeur I_{c} située près du bord de la spire. Il est bien évident que d'autres configurations à zones CTE modifiées sont possibles selon les formes des fenêtres du masque 5, et que ces configurations peuvent concerner une zone de spire, plusieurs spires, voire tout le spiral.

En se référant maintenant à la figure 9, on voit qu'il est possible, avant d'effectuer l'attaque chimique, de soumettre des spires ou zones de spire à une nouvelle illumination UV à travers un masque 6 qui, dans cet exemple, comporte des fenêtres 6d ayant la même largeur que le spiral. En choisissant une irradiation UV appropriée, par exemple un laser Eximer KrF₂ à 248 nm et en contrôlant le temps d'exposition, on peut modifier le coefficient thermique du module de Young de la valeur initiale CTE₀ à une valeur CTE₂ dans une zone 12 qui pénètre seulement une partie h' de la hauteur h du spiral.

En pareil cas, il est souhaitable d'effectuer l'illumination du spiral sur les deux faces de celui-ci comme représenté à la figure 10_{c}.

Si on veut effectuer une telle modification pour l'ensemble des spires, il est bien évident qu'aucun masque n'est nécessaire. Il est alors envisageable d'effectuer une telle illumination UV, une fois le spiral monté pour faire un ajustement fin de la valeur du CTE et par là-même de la fréquence.

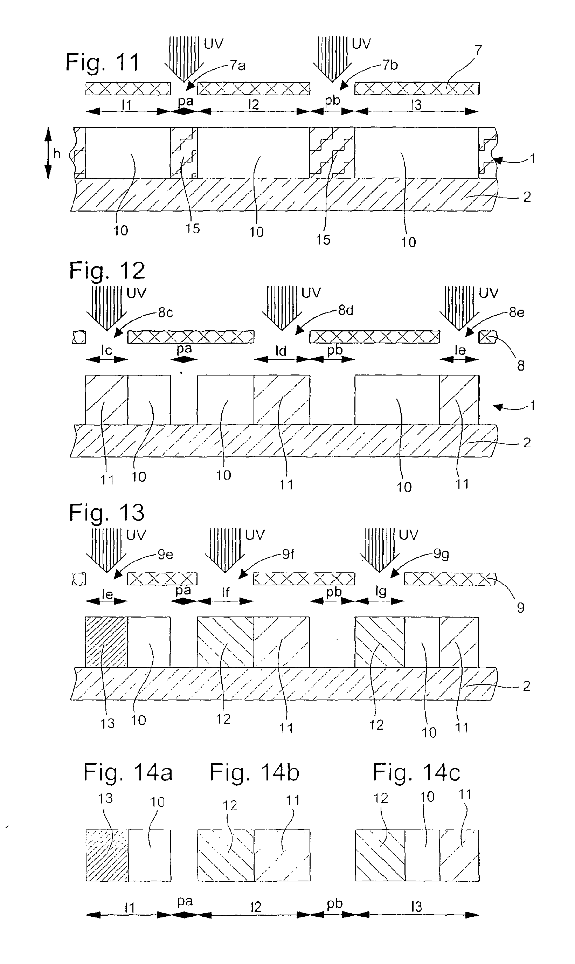

Les figures 11 à 14c illustrent un deuxième procédé de fabrication ainsi qu'un certain nombre de variantes qui seraient également applicables au premier procédé. Dans une première étape représentée à la figure 11, on fixe une plaque de verre 1 d'épaisseur h, ayant les caractéristiques indiquées au début, sur un substrat 2 insensible aux attaques acides. Le substrat 2 est par exemple une plaque de céramique.

On effectue ensuite la conformation du spiral par illumination UV à travers un masque 7 dont les fenêtres 7a, 7b correspondent aux espaces libres entre les spires et dont les parties opaques déterminent le contour planaire du spiral. Comme on le voit, en choisissant un masque 7 approprié il est possible de concevoir le contour du spiral avec un pas variable pₐ, p_{b}, etc..., avec une largeur variable I₁, I₂, I₃, etc...., ou avec les deux. Comme précédemment, est complétée par un traitement thermique à haute température pour fragiliser les zones qui viennent d'être illuminée.

Dans l'étape suivante, non représentée, on élimine les parties illuminées par attaque acide comme indiqué dans le premier procédé.

Dans l'étape suivante représentée à la figure 12, on effectue une illumination UV à travers un deuxième masque 8 dont les fenêtres 8c, 8d, 8e vont définir des zones 11 de spires dont le coefficient thermique du module de Young sera modifié de la valeur CTE₀ à la valeur CTE₁, en effectuant éventuellement un traitement thermique complémentaire à haute température.

En utilisant un masque supplémentaire 9, comme représenté à la figure 13, et en faisant varier les conditions d'illumination UV, de nouvelles fenêtres 9ₑ, 9f, 9g vont définir de nouvelles zones 12 du spiral pour lesquels le coefficient thermique du module de Young aura été modifié à une valeur CTE₂, voire des zones 13 où il aura été modifié à une valeur CTE₃ si des fenêtres, ou des zones de fenêtre des masques 8 et 9 coïncident, comme c'est le cas pour les fenêtres 8c et 9e. Les zones modifiées peuvent éventuellement être soumises à un traitement thermique complémentaire à haute température.

Dans une dernière étape représenté au figures 14a et 14b, on sépare le spiral du substrat 2. Dans cet exemple on a obtenu des spires ou zones de spires ayant respectivement pour valeurs de CTE, CTE₃/CTE₀ (fig. 14a), CTE₂/CT₁ (fig. 14b), CTE₂/CTE₀/CTE₁.

En jouant sur la forme des masques et/ou leur nombre, l'homme de métier peut concevoir d'autres variantes sans sortir du cadre de l'invention pour améliorer les propriétés mécaniques d'un spiral en verre, et notamment son insensibilité aux variations de température, qui sont néfastes à l'isochronisme.

## Revendications

1. Spiral en verre pour mouvement d'horlogerie comportant des spires de hauteur h et localement une largeur I, **caractérisé en ce qu'**il est réalisé en un verre photostructurable ayant pour épaisseur la valeur h et un coefficient thermique du module de Young (CTE₀) voisin de zéro.

2. Spiral en verre selon la revendication 1, **caractérisé en ce que** tout le spiral ou des zones choisies de spires ont un coefficient thermique du module de Young (CTEᵢ) modifié par rapport au coefficient initial (CTE₀) du verre photostructurable utilisé, ladite modification étant obtenue par irradiation UV, éventuellement complétée par un traitement thermique à haute température.

3. Spiral en verre selon la revendication 2, **caractérisé en ce que** la modification de CTE₀ en CTEᵢ est effectuée pour une ou plusieurs zones du spiral, sur toute la largeur de la spire, les CTEᵢ de chaque zone pouvant avoir des valeurs différentes.

4. Spiral en verre selon la revendication 2, **caractérisé en ce que** la modification de CTE₀ en CTEᵢ est effectuée sur une partie de leur largeur, une même zone de spire pouvant avoir des valeurs, CTEᵢ différentes.

5. Spiral en verre selon une quelconque des revendications 1 à 4, **caractérisé en ce que** la modification du CTE₀ est effectuée sur seulement une partie de la hauteur des spires.

6. Spiral en verre selon la revendication 4, **caractérisé en ce qu'**une zone de spire comporte localement plus de deux CTEᵢ différents.

7. Procédé de fabrication d'un spiral en verre pour mouvement d'horlogerie, formé de spires à section rectangulaire de hauteur h, de largeur I, et ayant entre elles un pas p, **caractérisé en ce qu'**il comporte les étapes consistant à :
a) prendre une plaque d'épaisseur h en verre photostructurable dont la valeur du coefficient thermique du module de Young CTE₀ est voisine de zéro;
b) effectuer une illumination UV à travers un premier masque (3) dont les fenêtres (3a) correspondent aux espaces devant ultérieurement être libérées entre les spires;
c) effectuer un traitement thermique à haute température;
d) effectuer une illumination UV à travers un deuxième masque (5) sur des zones de spire dont on veut modifier le coefficient thermique du module de Young de la valeur initiale CTE₀ à une valeur CTE₁, et
e) effectuer une attaque chimique pour éliminer les zones ayant été traitées dans les étapes b) et c).

8. Procédé selon la revendication 7, **caractérisé en ce qu'**on effectue en outre un traitement thermique après l'étape e).

9. Procédé selon les revendications 7 ou 8, **caractérisé en ce qu'**on répète au moins une fois l'étape d) avec un masque supplémentaire (6) dont les fenêtres (6d) correspondent à des zones de spires dont on veut modifier le coefficient thermique initial du module de Young à une valeur CTE₂.

10. Procédé selon la revendication 9, **caractérisé en ce que** le deuxième masque (5) et le masque supplémentaire (6) ont des zones de fenêtres communes permettant de modifier le coefficient thermique initial du module de Young à une valeur CTE₃.

11. Procédé de fabrication d'un spiral en verre pour mouvement d'horlogerie formé de spires à section rectangulaire de hauteur h, de largeur I et ayant entre elles un pas p, **caractérisé en ce qu'**il comporte les étapes consistant à :
a) fixer sur un substrat résistant aux attaques acides une plaque d'épaisseur h en verre photostructurable dont la valeur du coefficient thermique du module de Young CTE₀, est voisine de zéro;
b) effectuer une illumination UV à travers un premier masque (7) dont les fenêtres (7a, 7b) ont le même contour que les espaces libres entre les spires;
c) effectuer un traitement thermique à haute température;
d) effectuer une attaque chimique des zones illuminées à travers les fenêtres du premier masque pour séparer les spires maintenues à leur base sur le substrat;
e) effectuer une deuxième illumination UV à travers un deuxième masque (8) dont les fenêtres (8c, 8d, 8e) correspondent à des zones de spires dont on veut modifier le coefficient thermique du module de Young de la valeur initiale CTE₀, à une valeur CTE₁, et
f) séparer le spiral du substrat.

12. Procédé selon la revendication 11, **caractérisé en ce qu'**on effectue en outre un traitement thermique entre les étapes e) et f).

13. Procédé selon les revendications 11 ou 12, **caractérisé en ce qu'**on répète au moins une fois l'étape e) avec un masque supplémentaire (9) dont les fenêtres correspondent à des zones de spires dont on veut modifier le coefficient thermique du module de Young à une valeur CTE₂.

14. Procédé selon la revendication 13, **caractérisé en ce que** le deuxième masque (8) et le masque supplémentaire (9) ont des zones de fenêtres communes permettant de modifier le coefficient thermique du module de Young à une valeur CTE₃.

15. Procédé selon les revendications 7 ou 11, **caractérisé en ce que** le masque utilisé (5, 7) pour définir le contour du spiral comporte des fenêtres permettant de faire varier le pas p entre les spires, et/ou leur largeur l.
